# EUROPEAN PATENT APPLICATION

(11) **EP 1 443 554 A1**
(43) Date of publication of application: **04.08.2004**
(21) Application number: 03425036.5
(22) Date of filing: 27.01.2003
(51) Int. Cl.: H01L 23/373, H01L 25/16, H03K 17/567

(54) **Package for semiconductor devices**

(71) Applicant: STMicroelectronics S.r.l., 20041 Agrate Brianza (Milano) (IT)
(72) Inventor: Difalco, Luca, 97100 Ragusa (IT); Scollo, Rosario, 95045 Misterbianco (CT) (IT)
(74) Representative: Mittler, Enrico

(57) **Abstract**

A package for at least a first (Q) and a second (M) semiconductor device allocated respectively in a first die (1) and in a second die (2) is described. The package (100, 200) comprises a layer DBC (8) including a first metal layer (9), a second metal layer (11) and a ceramic material layer (10) interposed between said first (9) and second (11) metal layers and the second die (2) of the second device (M) is attached with said second metal layer (11). The package (100, 200) comprises a further metal layer (5) to which said first metal layer (9) of the layer DBC (8) and said first die (1) of said first device (Q) are attached.

## Description

The present invention refers to a package for semiconductor devices.

Packages for semiconductor devices of the same type are generally known, for example for MOSFET or IGBT transistors or others. Said packages may comprise one or more devices of the same type in accordance with the circuit topologies that a single package must comprise. However in the case of a circuit topology comprising MOS and bipolar power transistors a single package comprising both of them cannot be used. In fact for the vertical power MOSFETs and for the bipolar transistors where the collector terminal is allocated on the bottom of the device, by using a single package it would be risked of doing a short-circuit between the drain terminal and the collector terminal.

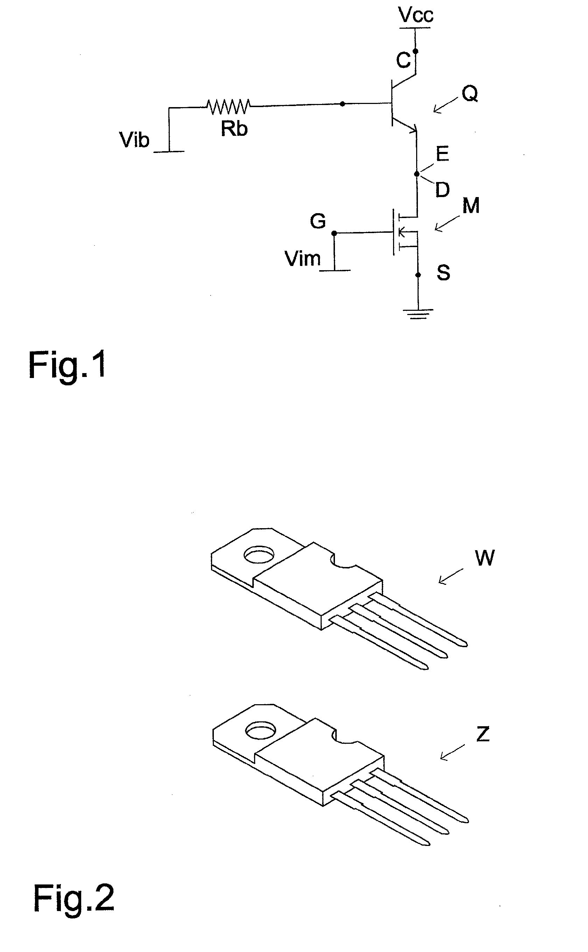

For example, in a cascode circuit topology comprising a bipolar transistor, particularly a high voltage power transistor, and a MOS transistor, particularly a low voltage power MOS transistor, a single package cannot be used including both of the above mentioned devices which therefore are inserted in different packages and coupled outside the packages. A cascode circuit is shown schematically in Figure 1 which comprises an-channel MOS transistor M and a npn bipolar transistor Q. The transistor MOS M has the source terminal S connected to ground, the gate terminal G connected with a voltage Vim and the drain terminal connected with the emitter terminal E of the bipolar transistor Q having the base terminal connected with a voltage Vib through a base resistance Rb and the collector terminal C connected with a supply voltage Vcc. The cascode circuit in Figure 1 is formed by inserting two transistors inside different packages (which are indicated in Figure 2 by the symbols W and Z) and by performing the suitable external connections.

A technology actually used for packaging a semiconductor device is the DBC technology (Direct Bonding on Copper). Such technology provides the soldering of a semiconductor device with a layer DBC formed by two copper layers and a ceramic material layer interposed between them. These DBC layers have better features of thermal resistance, electric insulation, mechanical severity, etc.

In view of the state of the art described, it is an object of the present invention to provide a package for at least two semiconductor devices.

According to present invention, such object is obtained by means of a package for at least a first and a second semiconductor device allocated respectively in a first die and in a second die , said package comprising a layer DBC including a first metal layer, a second metal layer and a ceramic material layer interposed between said first and second metal layers, the second die of said second device being attached with said second metal layer, characterized by comprising a further metal layer to which said first metal layer of the layer DBC and said first die of said first device are attached.

Particularly the two semiconductor devices are a bipolar transistor and a MOS transistor.

The features and the advantages of the present invention will be made evident by the following detailed description of embodiments thereof, shown as not limiting examples in the annexed drawings, wherein:
Figure 1 is an electric scheme of a cascode circuit;
Figure 2 is a perspective view of the two packages used for the two transistors in Figure 1 according to prior art;
Figure 3 is a plant schematic view of a package for two devices according to an embodiment of the present invention in a step preceding the encapsulation;
Figure 4 is a schematic cross section view of the structure inside the package in Figure 3;
Figure 5 is a perspective view of the package in Figure 3 after the encapsulating step;
Figure 6 is a perspective view of a package according a variant of the embodiment of the present invention;
Figure 7 shows a graph of the collector current as a function of the collector-source voltage for the package in Figure 3.

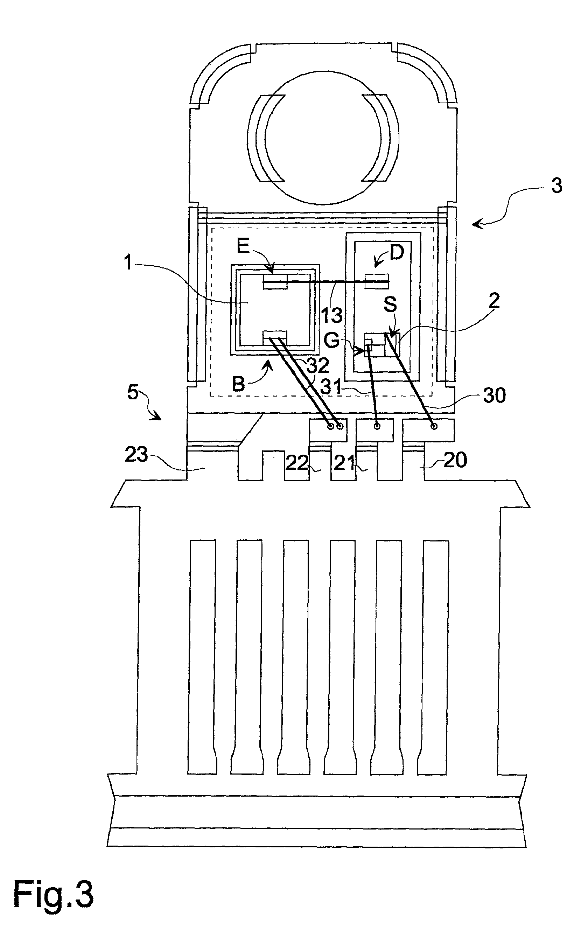

Referring to Figures 3-5 a structure 3 inside a package 100 for two semiconductor devices according to present invention is shown. The two semiconductor devices are preferably constituted by a bipolar transistor and by a MOS transistor, for example the transistors forming the cascode circuit in Figure 1, respectively the bipolar transistor Q and the MOS transistor M the respective dies of which will be indicated by the numbers 1 and 2. The two dies 1 and 2 are allocated in the structure 3 inside the package 100.

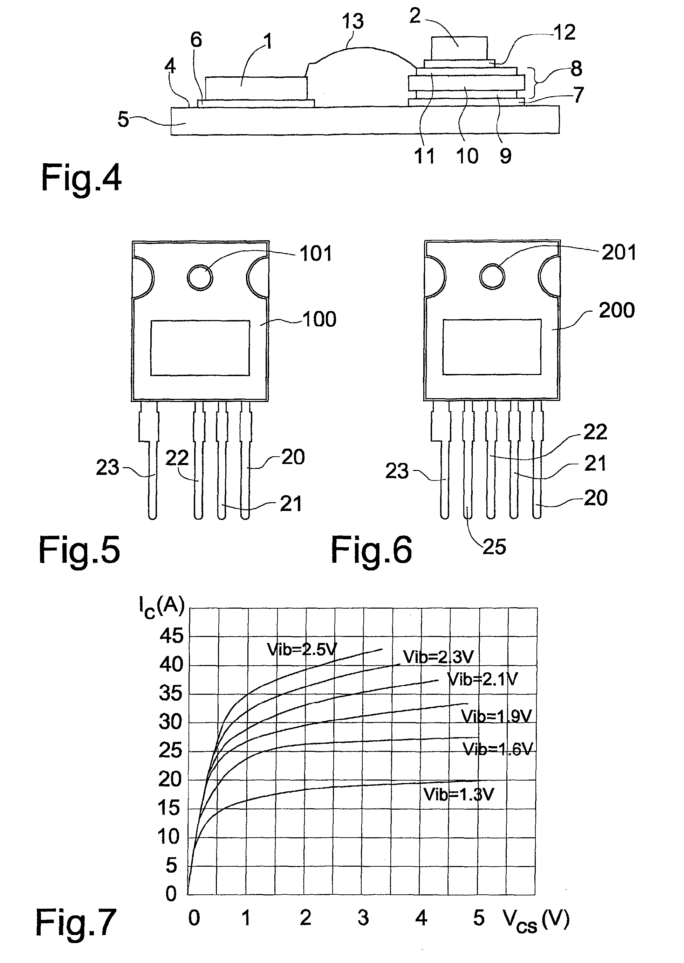

More precisely, as shown in Figure 4, the die of the bipolar transistor Q is attached directly over the top surface 4 of a conductor metal layer 5, generally called leadframe, by means of a soldering layer 6; the metal layer 5 is placed on the bottom of the structure 3 and of the package 100.

On the same top surface 4 of the layer 5, in a zone away from the zone where the die of the bipolar transistor Q is attached, a layer DBC 8 is attached by means of a further soldering layer 7. The layer DBC 8 comprises, in a bottom-up layer succession, a first copper layer 9, a ceramic material layer 10 for example a layer of Al2O3 and a second copper layer 11. On the second copper layer 11 the die of the MOS transistor 2 is soldered by means of another soldering layer 12,.

Then the connection between the drain terminal D of the MOS transistor M with the emitter terminal E of the bipolar transistor Q is formed by means of a conductor wire 13 preferably of aluminium. The drain terminal of the transistor M finds on the bottom of the die 2 and it is therefore connected with the second copper layer 11 as shown in figure 4.

The leadframe 5 is suitable patterned for achieving the conductor terminals 20-23, called even leads, of the structure 3 of the package 100 (Figure 3). More precisely the source S and gate G terminals of the transistor M are connected by means of respective conductor wires 30 and 31 with the leads 20 and 21 and the base terminal B of the bipolar transistor Q is connected with the lead 22 by means of further conductor wires 32; the leads 20-22 are disconnected from the layer 5. The collector terminal C of the bipolar transistor Q which is allocated on the bottom of the die 1 is directly connected with the leadframe 5 and can be brought out the structure 3 of the package 100 by means of the lead 23.

After the cutting of the leads 20-23 and the encapsulation of the structure 3 the package 100 is formed with pins corresponding to the leads 20-23 (Figure 5). The package 100 has a hole 101 for the connection with a suitable heatsink.

As a variant to the embodiment of the invention a package 200 can be formed where a further pin 25 is provided which corresponds to a lead connected with the common terminal of the emitter E of the bipolar transistor Q and of the drain D of the MOS transistor M in order to control the current or the voltage on said common terminal (Figure 6). The package 200 also shows a hole 201 for the connection with a suitable heatsink.

By using the package 100 or 200 for the cascode circuit structure in Figure 1 all the external connections between the two transistors are eliminated and therefore the parasitic effects due to the external connections are deleted. Also a considerable cost reduction is obtained because a single package is used instead of the two packages of prior art and only four or five pins instead of the six pins of the two packages of prior art are used.

The use of a single package for both the semiconductor devices and wherein the bipolar transistor is insulated by means of a ceramic layer, allows the use of a single heatsink without the necessity of providing a ceramic layer placed between the package and the same heatsink. The thermal resistance of the package 100 is lower than the thermal resistance of the sum of the two packages W and Z of prior art; this is due to the arrangement of the die 1 of the bipolar transistor Q which is attached to leadframe 5 is in contact with the heatsink while the die 2 of the MOS transistor M is insulated.

With a package 100 having a supply voltage Vcc=1000V, a collector current Ic=50A, an on-resistance Ron=25mΩ a total power dissipation of about 400W is obtained at a temperature of 25°C; the thermal resistance of the structure 3 of the package 100 with the values of Vcc=500V, Ic=30A, a base resistance Rb=0.15Ω, a gate-source voltage Vim=6V, with the source terminal connected to ground and a voltage Vib=2.5V is of about 0.31°C/W which by the use of a heatsink is lowered to about 0.05°C/W. In Figure 7 a graph of the collector current Ic as a function of the collector-source voltage Vcs is shown with different base voltages Vib with values Vim=6V and Rb=0.15Ω.

## Claims

1. Package for at least a first (Q) and a second (M) semiconductor device allocated respectively in a first die (1) and in a second die (2) , said package (100, 200) comprising a layer DBC (8) including a first metal layer (9), a second metal layer (11) and a ceramic material layer (10) interposed between said first (9) and second (11) metal layers, the second die (2) of said second device (M) being attached with said second metal layer (11), **characterized by** comprising a further metal layer (5) to which said first metal layer (9) of the layer DBC (8) and said first die (1) of said first device (Q) are attached.

2. Package according to claim 1, **characterized in that** said second device (M) is a MOS device and said first device (Q) is a bipolar device.

3. Package according to claim 2, **characterized in that** said bipolar device (Q) is a bipolar power transistor and said MOS device (M) is a MOS power transistor, said bipolar transistor (Q) having a terminal collector (C) which is connected directly with said further metal layer (5).

4. Package according to claim 1, **characterized in that** said first (Q) and second (M) devices are circuitally connected with each other.

5. Package according to claim 3, **characterized in that** said bipolar transistor (Q) is circuitally connected with said MOS transistor (M) for forming a cascode circuit.

6. Package according to claim 5, **characterized in that** said bipolar transistor (Q) has the emitter terminal (E) in common with the drain terminal (D) of said MOS transistor (M).

7. Package according to claim 6, **characterized by** comprising four pins (20-23), a first (22) and a second (23) pin being respectively connected with the base (B) and the collector (C) terminals of the bipolar transistor (Q) and a third (20) and a fourth (21) pin being connected with the source (S) and gate (G) terminals of the MOS transistor (M).

8. Package according to claim 7, **characterized by** comprising a further pin (25) adapted for controlling the signal at the emitter terminal (E) of the bipolar transistor (Q).
